# EUROPEAN PATENT APPLICATION

(11) **EP 4 678 975 A1**
(43) Date of publication of application: **14.01.2026**
(21) Application number: 24187380.1
(22) Date of filing: 09.07.2024
(51) Int. Cl.: F21V 8/00, G02B 6/12, G02B 6/122, G02B 6/42, G02B 27/09

(54) **A LIGHT EMITTING DEVICE, A DISPLAY, AND A METHOD FOR EMITTING LIGHT**

(71) Applicant: Imec VZW, 3001 Leuven (BE)
(72) Inventor: GEHLHAAR, Robert, 3020 Herent (BE); ROTTENBERG, Xavier, 3010 Kessel-Lo (BE); GENOE, Jan, 3272 Testelt (BE); FIGEYS, Bruno, 3001 Heverlee (BE)
(74) Representative: AWA Sweden AB

(57) **Abstract**

A light emitting device (100; 200) comprises: a plurality of light emitters (110); a plurality of light propagating units (120), each being associated with a group of light emitters (110a-b) and comprising: a waveguide (130) for coupling in light from different light emitters at different locations of an in-coupling end (132), wherein the waveguide (130) is a multimode waveguide for propagating light in dependence of the characteristics of the light for combining the light emitted by the light emitters (110a-b) at a transmitting end (134); a funnel element (140) with a smaller cross-section at a receiving end (142) than at an output end (144), wherein the receiving end (142) is arranged to couple the light at the transmitting end (134) into the funnel element (140) for propagating the light to the output end (144) for output of emitted light being a combination of light of the different characteristics.

## Description

### Technical field

The present description relates to emission of light, such as emission of light in a display.

### Background

Micro-LED (light emitting diode) displays is an emerging technology. A micro-LED display comprises an array of small LEDs, wherein each LED forms a pixel of the display and wherein the array of LEDs together emit light forming an image of the display.

The micro-LED display allows providing a large number of pixels in a very small area, providing high resolution displays. The LEDs also have a short response time allowing for a high frame rate of images. For these reasons, micro-LED displays are advantageously used in augmented, mixed, and virtual reality displays.

In such applications, a high directionality of emitted light is required since the display may be viewed from a close distance. In other words, the emitted light should be output in a small emission cone. Thus, focusing elements may be provided for each of the light emitting pixels. Without focusing element, light emission is of wide angle and only a limited amount of the emitted photons is within a target emission cone for reaching the viewer which reduces light and power efficiency of the micro-LED display. Most common elements to enhance directionality are the implementation of spherical, parabolic, or freeform reflectors below the emitter and/or microlenses above the emitter. On that scale, aberrations of microlenses cause anisotropic intensity distribution in the emission cone in particular for neighboring emitters of different color.

Thus, there is a need for providing light emitting devices that may control directionality of emitted light and that may handle emission of different colors.

### Summary

An objective of the present description is to provide a light emitting device providing accurate control of directionality of light, such that a narrow emission cone of a light emitter of the light emitting device is provided. Another objective of the present description is to provide a light emitting device which enables output of a uniform emission cone for a plurality of colors.

These and other objectives are at least partly met by the invention as defined in the independent claims. Preferred embodiments are set out in the dependent claims.

According to a first aspect, there is provided a light emitting device comprising: a plurality of light emitters comprising at least a first set of light emitters and a second set of light emitters, wherein light emitters belonging to different sets are configured to emit light of different characteristics; a plurality of light propagating units, wherein each light propagating unit is associated with a group of light emitters of the plurality of light emitters, wherein the group of light emitters comprises light emitters belonging to different sets, wherein each light propagating unit comprises: a waveguide having an in-coupling end and a transmitting end, wherein the waveguide is configured to couple in light emitted by the group of light emitters at the in-coupling end, wherein the waveguide is arranged in relation to the light emitters of the group to receive light from different light emitters of the group at different locations of the in-coupling end, wherein the waveguide is a multimode waveguide configured to propagate light through the waveguide in dependence of the characteristics of the light for combining the light emitted by the group of light emitters at the transmitting end; a funnel element having a receiving end and an output end, wherein a cross-section of the funnel element at the receiving end is smaller than a cross-section of the funnel element at the output end and wherein a cross-section of the funnel element at the receiving end is smaller than a cross-section of the waveguide at the transmitting end, wherein the receiving end of the funnel element is arranged in relation to a portion of the transmitting end to couple the light combined by the waveguide at the transmitting end into the funnel element, and to propagate the light to the output end for output of emitted light by the light propagation unit, wherein the emitted light is a combination of light of the different characteristics emitted by the light emitters belonging to the different sets.

The light emitting device comprises light propagating units which are associated with a group of light emitters. Each light propagating unit may be configured to control output of emitted light. By the light propagating unit being associated with the group of light emitters, the light propagating unit is configured to control output of emitted light from all light emitters in the group. This implies that directionality of the light from several light emitters may be controlled by a single light propagating unit.

In particular, the waveguide of the light propagating unit may be configured to propagate light in dependence of the characteristics of light. By placing the light emitters of different characteristics in different specific locations in relation to the in-coupling end of the light propagating unit, the light from the different light emitters may then be combined by the waveguide and coupled into a single funnel element. The funnel element may have a small cross-section at its receiving end, such that light from the waveguide is coupled into a small cross-section ensuring high directionality of the light.

The spatial relation of light of different characteristics at the in-coupling end may be adapted such that the multimode waveguide is configured to combine the light at the transmitting end.

The waveguide may have a small cross-section at the in-coupling end such that also the location of the in-coupling end related to different light emitters may be very small. For instance, the waveguide may be used with light emitters having a size of 200 nm or even smaller. This implies that the light emitting device may provide a very high resolution of emitted light. The light emitting device is thus suited for use in applications requiring a high resolution, such as in displays for use in in augmented, mixed, and virtual reality applications.

It is a realization of the present description that a light propagating unit which is known from applications of separating light for light detection may instead be used for combining light of different characteristics into a common output beam. Thus, the light emitting device may make use of a light propagating unit known from imaging devices, such as a light propagating unit disclosed in EP3770660. However, in the light emitting device of the first aspect, the light propagating unit is used for combining light instead of for separating light by allowing light to propagate in an opposite direction to propagation of light in the imaging device.

The waveguide may form a dual mode waveguide, providing a beating between modes for light propagating through the waveguide. The waveguide may further provide effective refractive index differences between light of different characteristics, such as light of different wavelengths. This implies that the waveguide may be configured such that light being coupled into the in-coupling end of the waveguide at different locations of the in-coupling end may exit the dual mode at a location corresponding to the receiving end of the funnel element. Thus, light of different characteristics being coupled into the waveguide at different spatial locations may be combined and exit the waveguide at the same location to enter the funnel element.

The funnel element may be a single-mode waveguide. Since the funnel element has a larger cross-section at the output end than at the receiving end, the mode propagating in the funnel element becomes wider at the output end of the funnel element. Conservation of etendue causes an emission cone from the output end of the funnel element to be narrower than a cone entering the light propagating unit, because the mode is wider at the output end. Thus, the light emitting device may provide high directionality of emitted light.

The waveguide may be formed in a single piece. However, the waveguide may alternatively be formed by a plurality of portions being arranged close to each other and extending in parallel along a direction from the in-coupling end to the transmission end. The light propagating in one portion may be coupled to other portions such that light may be combined by the waveguide. The funnel element may be physically connected to one of the portions and may be configured to receive combined light including light that is initially coupled into another one of the portions of the waveguide, to which the funnel element is not physically connected.

In this context the term "light" should be allowed a broad interpretation, not limited to visible electromagnetic radiation. Rather, the term "light" may also include for example ultraviolet light, infrared light, or combinations thereof.

The light emitter is an element configured to emit light. The light emitter may be configured to generate light but may alternatively be configured as a light waveguide that receives light from a light source and outputs light at an emission end of the light waveguide. In this respect, the light emitter may comprise an optical fiber with an output end arranged in relation to the appropriate location of the in-coupling end of the waveguide of the light propagating unit.

The light emitter may be small so as to provide emission of light from a small, confined area. The light emitter may for instance be formed by a light emitting diode (LED) or a laser, such as a semiconductor laser.

The light emitters are configured to emit light of different characteristics. The different characteristics of light may be different wavelengths of light. However, in some embodiments, the different characteristics of light may be different polarizations, such as different orientations of linear polarizations. The different characteristics of light may as another alternative be a combination of different wavelengths and/or polarizations.

The plurality of light emitters may comprise sets of light emitters, wherein each light emitter in a set is configured to emit light with same or similar characteristics. Thus, a set of light emitters is defined as comprising the light emitters that emit light with particular characteristics.

The plurality of light emitters comprises at least two different sets of light emitters but may comprise further sets of light emitters. Each set of light emitters is configured to emit light with unique characteristics.

The plurality of light emitters may be arranged in a one-dimensional or two-dimensional array. Thus, the plurality of light emitters may be regularly arranged in the array. However, it should be realized that the plurality of light emitters need not necessarily be regularly arranged.

Each light propagating unit may be associated with a group of light emitters. The light emitters of a group belong to different sets of light emitters. This implies that the light emitters of different sets may be alternatingly arranged in an array such that neighboring light emitters belong to different sets. This further implies groups of light emitters that are spatially close to each other may be formed, wherein the light emitters in the group belong to different sets and may be associated with a single light propagating unit.

The light propagating units may be associated with identical groups of light emitters. Thus, each group of light emitters may have a same composition of light emitters belonging to different sets. Thus, the combination of light output from the light propagating units may have the same characteristics for each of the light propagating units. However, it should be realized that different light propagating units may be associated with groups of light emitters having different compositions. For instance, a first type of light propagating unit may be associated with two light emitters emitting blue and yellow light, respectively, whereas a second type of light propagating unit may be associated with two light emitters emitting cyan and red light, respectively.

The group of light emitters comprising light emitters belonging to different sets implies that a group of light emitters may comprise at least one light emitter, such as one light emitter, belonging to the first set and at least one light emitter, such as one light emitter, belonging to the second set. Also, it should be realized that the light emitters in the group may not need to have mutually unique characteristics. For instance, the group of light emitters may comprise two light emitters from the first set emitting light with a first characteristic and two light emitters from the second set emitting light with a second characteristic. Also, the group of light emitters may comprise one or more light emitters from each set of light emitters. However, according to an alternative, the group of light emitters may comprise light emitters from only some of the sets, whereas other groups of light emitters may comprise light emitters from other sets.

Light emitters being configured to emit different wavelengths should be construed as the spectral content of emitted light from different light emitters not being identical. Each light emitter may emit light in a wavelength band, which may be narrow or broad. Light emitters being configured to emit different wavelengths implies that the light emitters emit light in different wavelength bands, which may be partially overlapping but not identical.

In some embodiments, light emitters may be configured to emit light having a spectral profile such that light is emitted in a plurality of wavelength bands. Light emitters being configured to emit different wavelengths implies that the light emitters emit light with different spectral profiles, which may include partially or completely overlapping wavelength bands but not identical compositions of wavelength bands.

The waveguide being configured to receive light from different light emitters at different locations of the in-coupling end should be construed as the light from different light emitters not being provided in identical areas of the in-coupling end. The light from a light emitter may have a cross-section at the in-coupling end which may be spatially separate from a cross-section of light from another light emitter of the group. However, the cross-sections may partially overlap.

By the term "light propagating unit" is here meant any unit, device, and/or element with the capability of propagating light based on the characteristics of the light.

Given only as an example, incident light of several wavelengths may be propagated through the light propagating unit such that different wavelengths are received at different spatial locations of the in-coupling end, wherein a direction of propagation is altered based on the wavelength of the light, such that the different wavelengths are combined. By the present arrangement, different wavelengths may be output as a combination of light provided by the light emitting device.

The light propagating unit comprises a waveguide having an in-coupling end and a transmitting end. The waveguide is configured to receive the light from the group of light emitters at the in-coupling end of the waveguide.

The in-coupling end may be facing the group of light emitters. The in-coupling end may be in direct physical contact with the light emitters.

The waveguide is further configured to propagate the light from the in-coupling end to the transmitting end. The waveguide may be, but is not required to be, tapered towards the in-coupling end such that a cross-section of the in-coupling end is smaller than a cross-section of the transmitting end. Alternatively, the sides of the waveguide may be parallel. As the waveguide is a multimode waveguide, the waveguide will propagate the light through the waveguide in dependence of characteristics of light, such as wavelength of light. In this manner, the light of different characteristics provided at the in-coupling end may be combined at the transmitting end.

The light propagating unit further comprises a funnel element having a receiving end and an output end. The funnel element is configured to receive the light from the transmitting end of the waveguide at the receiving end of the funnel element. The funnel element may be arranged in relation to the transmitting end of the waveguide such that light is coupled into the funnel element.

The transmitting end of the waveguide may be in direct physical contact with the receiving end of the funnel element. Alternatively, a gap may be formed between the receiving end and the transmitting end. As yet another alternative, the light propagating unit may be made of a single piece of material such that the funnel element and the waveguide are different portions of the single piece.

By way of example, one or more additional layers may be provided between the transmitting end and the receiving end. By way of example, the one or more additional layers may enhance the coupling of light between the waveguide and the funnel element.

The waveguide may have a cross-section at the transmitting end that is smaller than the cross-section of the output end of the funnel element. Thus, in order for light to be combined into the receiving end of the funnel element, the funnel element is tapered such that the receiving end of the funnel element has a cross-section that is not larger than the cross-section of the transmitting end of the waveguide. Typically, the funnel element is tapered such that the receiving end of the funnel element has a cross-section that is smaller than the cross-section of the transmitting end of the waveguide.

The funnel element is tapered such that the cross-section of the output end is larger than the cross-section of the receiving end. The funnel element may be arranged in relation to the transmitting end of the waveguide such that light is efficiently coupled into the funnel element. The light may further be guided by the funnel element for controlling a direction of light being output at the output end. By way of example, the funnel element may be tapered such that the light may be coupled into the funnel element at a very small area at the receiving end having a size in the same order of magnitude as the wavelength of the light. The funnel element may further be tapered such that light being coupled into the funnel element is confined within the funnel element propagating therein. By way of example, the receiving end may have a width in the range of 200 nm to 600 nm.

By way of further example, a width of the output end may be adapted to provide an output area corresponding to a pitch of repeated elements in the light emitting device. The width of the output ends may thus be adapted to fill an emission plane from which light is output by the light emitting device. Hence, the width of the output ends may be dependent on size of the group of light emitters associated with the light propagating unit.

According to an embodiment, an adiabatic tapering of the funnel element is provided such that an angle of a sidewall to a normal to the receiving end and the output end is larger at the receiving end. This may be advantageous in ensuring that light coupled into the receiving end is propagated within the funnel element to the output end and may be important if a steep tapering of the funnel element is used.

However, according to another embodiment, a sidewall of the funnel element may extend along a straight line between the receiving end and the output end. This implies that a shape of the funnel element is simple and may still provide a funnel element that effectively propagates the light received at the receiving end to the output end, in particular if a length of the funnel element is larger or much larger than a size of the wavelength of light.

The waveguide and the funnel element are configured for combining the light emitted by the group of light emitters to provide a combination of light of the different characteristics emitted by the light emitters. This implies that the output of emitted light by the light propagation unit may provide light propagating along an optical axis such that an output light beam is arranged centered around the optical axis. The light of different characteristics may share the optical axis.

The light propagating unit may be configured to provide etendue conservation of the light received by the group of light emitters. Thus, each light emitter may output light in a small area of a light beam and with a large solid angle such that light received at the in-coupling end of the waveguide has a small area and large angular range. The light propagation unit may provide output of emitted light at the output end in a relatively large area with a small solid angle. It should be realized that the output end may correspond to a combined area of the group of light emitters, wherein the entire area of the output end is used for output of light from each of the light emitters. Thus, an area of the beam is increased in relation to an area of one of the light emitters in the group, whereby a solid angle of the emitted light beam may be decreased while etendue is conserved. Thus, the light emitting device facilitates providing directionality of the light from the group of light emitters.

According to an embodiment, the plurality of light emitters is arranged in an emitter plane, wherein the plurality of light propagating units is arranged with surfaces of the in-coupling ends of the waveguides of the light propagating units being parallel with the emitter plane.

This may facilitate coupling of light from the light emitters into the in-coupling ends of the waveguides.

According to an embodiment, the plurality of light propagating units is formed in a layer integrated with the plurality of light emitters, wherein the waveguides and funnel elements of the light propagating units are formed by a material having a high refractive index surrounded by a material having a low refractive index.

Thus, the light emitting device may be very compact with the light propagating units being integrated with the light emitters. Also, thanks to forming of the plurality of light propagating units in a layer, the plurality of light propagating units may be formed in parallel by processing the layer.

The waveguides and the funnel elements of the light propagating units may be formed from the same material. This may ensure desired guiding of light and may also facilitate simple manufacturing as a single material may be used for forming the light propagating unit. However, according to an alternative, the waveguides and the funnel elements are formed from different materials, which may have different or same refractive indices.

The material of the light propagating units may have a high refractive index in that, in comparison, the material of the light propagating units has a higher refractive index than the material surrounding the light propagating units. This may facilitate light being maintained propagating in the light propagating units. Thus, no or small amounts of light will escape the light propagating units and enter into the surrounding material.

The material of which the funnel element and/or waveguide of the light propagating unit is made of may depend on the wavelength range for which the light propagating unit is designed. Given as non-limiting examples, if the light propagating unit is designed for propagation of visible light, materials such as SiₓNₓ, TiOₓ, or NbOₓ may be used in a SiOₓ environment. Given as further non-limiting examples, if the light propagating unit is designed for propagation of light in the near infrared (NIR) range, materials such as amorphous Si, or Carbon rich amorphous silicon may be used.

The light emitting device may be configured to output light from an emission plane defined by the plurality of light propagating units and to output light from the plurality of light emitters. The emission plane may be parallel with the in-coupling ends of the waveguides. This implies that the light emitting device may have a generally flat shape. This may be advantageous for mounting the light emitting device in an apparatus with other components.

It should be realized that the emission plane may be defined as a plane including a central point of the output end of each of the funnel elements. In an embodiment, the output ends of the funnel elements are arranged in the emission plane. This implies that the light emitting device may have a smooth surface at the emission plane.

The light propagating units may be configured to output emitted light such that central axes of emitted light from different light emitters are parallel to each other. Further, the central axes of emitted light may also be parallel to a normal of the emission plane.

However, it should be realized that the output ends may be tilted, such that the output ends are not parallel with the emission plane. This may be used for providing output of emitted light, wherein the central axes of emitted light are not necessarily parallel to the normal of the emission plane.

According to an embodiment, the funnel element is asymmetrically arranged in relation to the waveguide such that a central funnel axis at the receiving end is displaced from a central waveguide axis at the transmitting end.

This may facilitate coupling of light from the transmitting end of the waveguide into the funnel element. Hence, a very large proportion, such as almost all or all, of the light propagating through the waveguide may be coupled into the funnel element.

The asymmetrical placement of the funnel element in relation to the waveguide may also affect an angle at which light is output from the funnel element in relation to a normal of the transmitting end of the waveguide. Thus, for a light propagating unit to be configured to output emitted light along a normal to the emission plane, a certain displacement is preferred between the central axis of the funnel element at the receiving end and the central axis of the waveguide at the transmitting end. A displacement, and thus an asymmetric coupling, may provide a desired direction of light being output by the light propagating unit. The preferred displacement may be dependent on the size/width of the receiving end of the funnel element. Given as a non-limiting example, the receiving end may have a width in the range of 400 nm to 600 nm. Typically, a preferred displacement may be 90 nm in one direction in the plane of the transmitting end.

However, a light propagating unit having a different displacement may be configured to output emitted light in a different angular direction. Thus, for a different displacement, and thus a different asymmetric coupling, the light propagating unit may be configured to output light around a central axis that is tilted in relation to the normal of the emission plane. It should be realized that this angled output of emitted light may be achieved even though the output end of the funnel element is parallel with the emission plane.

By way of example, the preferred displacement for a light propagating unit to output emitted light centered around an axis that is at an angle with respect to the normal may be smaller than the displacement for providing output of emitted light along the normal to the emission plane.

It serves to mention that "the central axis of the funnel element at the receiving end" is a point in space located in a plane of the receiving end. Similarly, "the central axis of the waveguide at the transmitting end" is a point in space located in the plane of the transmitting end.

It should be understood that in case the funnel element and the waveguide are arranged such that the receiving end and the transmitting end are in direct physical contact with each other, or if the receiving end and the transmitting end are close to each other, the plane of the receiving end and the plane of the transmitting end may be considered to substantially coincide to form a common plane. The common plane may be interchangeably referred to as the plane of the receiving end and the plane of the transmitting end. Thus, the displacement between the central axis of the funnel element at the receiving end with respect to the central axis of the waveguide at the transmitting end may be a displacement in the plane of the receiving end.

Further, it should be understood that in case the funnel element and the waveguide are arranged such that the receiving end and the transmitting end are spaced apart, the plane of the receiving end and the plane of the transmitting end may not coincide but may rather form two separate planes. A displacement in the plane of the transmitting end may in such case be defined by the distance between the central axis of the waveguide at the transmitting end and the perpendicular projection of the central axis of the funnel element at the receiving end onto the plane of the transmitting end.

According to an embodiment, the central funnel axis is parallel to the central waveguide axis.

This may facilitate manufacturing of the light emitting device, since the funnel element may thus be arranged with the receiving end and the output end being parallel with the transmitting end of the waveguide. Also, the light emitting device may be provided with a smooth surface at the emission plane. This may also facilitate output of emitted light along an axis being parallel to the normal of the emission plane.

However, it should be realized that the central funnel axis need not necessarily be parallel to the central waveguide axis. This implies that the funnel element may be tilted in relation to the waveguide. The light propagating through the funnel element may propagate along the central funnel axis. Hence, by the funnel element being tilted, the light propagating unit may be configured to output light around a central axis that is tilted in relation to the normal of the emission plane (and the output ends of the funnel elements may in such case not be parallel with the emission plane).

In addition, as mentioned above, even though the central funnel axis is parallel to the central waveguide axis, the light propagating unit may be configured to output emitted light around a central axis that is not parallel with the normal of the emission plane. This may be achieved by the asymmetric arrangement of the funnel element in relation to the waveguide.

According to an embodiment, different light propagating units may be arranged with the funnel elements being differently asymmetrically arranged in relation to the waveguide. Thus, a first light propagating unit may have a funnel element being arranged such that the central funnel axis at the receiving end has a first displacement from the central waveguide axis at the transmitting end, whereas a second light propagating unit may have a funnel element being arranged such that the central funnel axis at the receiving end has a second displacement from the central waveguide axis at the transmitting end. This implies that the output of emitted light is not provided around parallel central axes. This may be utilized for forming a relation of output of emitted light from the different light propagating units. For instance, the light propagating units arranged at a periphery of an array may be configured to output emitted light along a central axis that is tilted towards a center of the array, whereas light propagating units arranged at a center of the array may be configured to output emitted light along a central axis that is parallel to the normal of the emission plane. This may be used for forming a focus of the emitted light from the plurality of light propagating units.

According to an embodiment, the light emitters belonging to the first set are configured to emit light of a first wavelength and the light emitters belonging to the second set are configured to emit light of a second wavelength, wherein the light propagating units being associated with a group of light emitters comprising a light emitter belonging to the first set and a light emitter belonging to the second set are configured to output emitted light being a combination of light of the first wavelength and light of the second wavelength.

Thus, the light emitting device may comprise light emitters that emit light of different wavelengths. Thanks to the light propagating units being configured to combine the light emitted by the group of light emitters, the light propagating units may be configured to combine light of different wavelengths and output emitted light being a combination of wavelengths. This may imply that the light emitting device may provide color uniformity for all observation angles within the emitted cone of light.

For instance, light propagating units may be associated with a group of light emitters that emit red, green, and blue light, respectively. Thus, the light propagating units may be configured to output emitted light being a combination of red, green, and blue light spanning an entire range of visible spectrum. It should be realized that, also or alternatively, one or more light emitters in the group may be configured to output light in the ultraviolet range and/or the infrared range.

According to an embodiment, the plurality of light emitters further comprises a third set of light emitters and a fourth set of light emitters, wherein the light emitters belonging to the third set are configured to emit light of a third wavelength and the light emitters belonging to the fourth set are configured to emit light of a fourth wavelength, wherein the plurality of light propagating units comprises a first set of light propagating units and a second set of light propagating units, wherein the light propagating units belonging to the first set are each associated with a group of light emitters comprising a light emitter belonging to the first set and a light emitter belonging to the second set and the light propagating units belonging to the first set are configured to output emitted light being a combination of light of the first wavelength and light of the second wavelength, and the light propagating units belonging to the second set are each associated with a group of light emitters comprising a light emitter belonging to the third set and a light emitter belonging to the fourth set and the light propagating units belonging to the second set are configured to output emitted light being a combination of light of the third wavelength and light of the fourth wavelength.

Thus, different light propagating units may be adapted to combine different wavelengths of light being emitted by the group of light emitters. This may be achieved by slight differences in shape and/or sizes of the light propagating units. Hence, the light propagating units may be configured to efficiently combine the wavelengths of light emitted by the group of light emitters associated with the respective light propagating units. By having different sets of light propagating units, the light propagating units may be adapted to different wavelengths of light such that the light emitting device may overall provide an efficient output of light within a broad range of wavelengths by using light propagating units of two or more sets.

For instance, the light emitters belonging to the first set may emit blue light, the light emitters belonging to the second set may emit yellow light, the light emitters belonging to the third set may emit cyan light, and the light emitters belonging to the fourth set may emit red light. Thus, the light propagating units of the first set may be configured to combine blue and yellow light, whereas the light propagating units of the second set may be configured to combine cyan and red light. The light propagating units of the first set and the light propagating units of the second set may be alternatingly arranged in an array to ensure that output of all wavelengths is spread over an entire area of the array.

However, it should also be realized that all light propagating units may be associated with identical groups of light emitters. Each group of light emitters may then comprise one light emitter from each set of light emitters. For instance, if there are four sets of light emitters, the group of light emitters may comprise four light emitters.

When a light propagating unit is associated with a group of light emitters including more than two light emitters, the light emitters in the group may be arranged along a straight line. Thus, light may be coupled into the in-coupling end of the waveguide at different locations along a line. This may facilitate combining of light of different wavelengths for combining the light at the transmitting end of the waveguide and coupling the combined light into the funnel element.

However, according to other embodiments, the light emitters in the group may be arranged in a two-dimensional array, such as a 2 x 2 array or a 3 x 3 array.

According to an embodiment, each light propagating unit is configured to output emitted light in an emission cone smaller than 40°, such as smaller than 30°.

It should be realized that the emission cone is a truncated cone, with a top face of the truncated cone being defined by the output end. In addition, it should be realized that the cone does not necessarily have a circular base.

The emission cone may be defined by an angle at an apex of the cone, being a maximum angle between two generatrix lines of the cone. Thus, the emission cone being smaller than 40° implies that the maximum angle between two generatrix lines at the apex of the cone is smaller than 40°. For instance, the emission cone may have an angle at the apex of the cone in a range of 20-30°.

The light propagating units may thus be configured to output emitted light with high directionality. This may be particularly useful for using the light emitting device in an augmented, mixed, or virtual reality display.

According to an embodiment, each of the light emitters has a light emitting area with a size across the light emitting area smaller than 500 nm, such as smaller than 300 nm, and wherein the output end of the funnel element of each of the light propagating units has a size across the output end larger than 500 nm, such as larger than 1 µm.

The output end may provide a scaling factor in relation to a light emitting area of the light emitter. For etendue conservation, this implies that the solid angle of the output of emitted light from the output end may be correspondingly smaller than the solid angle of emitted light from the light emitter. For instance, the scaling factor may be larger than 2, such as larger than 3.

A size across the light emitting area and/or a size across the output end may be defined by a diameter of a circular area or may be defined by a side of a square or rectangular area.

According to an embodiment, a size across the light emitting area of the light emitter may be 200 nm, whereas the size across the output end may be 1 µm. Thus, a scaling factor of 5 may be provided.

It should be realized that the light emitted from each one of the light emitters in the group will be propagated by the light propagating unit to be output across the entire area of the output end.

According to an embodiment, each of the light emitters comprises a light emitting diode comprising a iii-v compound semiconductor, an organic material, a quantum dot, or a perovskite material for emitting light.

For instance, an emitter material of the light emitter may be gallium arsenide (GaAs), aluminum gallium arsenide (AlGaAs), gallium arsenide phosphide (GaAsP), or aluminum gallium indium phosphide (AlGaInP).

The light emitters may comprise a material selected such that the light emitter is configured to emit light of a desired wavelength. The light emitters belonging to different sets may have different materials so as to be configured to emit light of different wavelengths.

According to an embodiment, the waveguide is a dual mode waveguide, and the funnel element is configured to propagate light of a single mode.

The dual mode waveguide may be configured to ensure that light is coupled into the funnel element at the receiving end. In addition, the single mode guiding by the funnel element may ensure that the mode becomes wider at the output end of the funnel element so that a solid angle of the output of emitted light from the output end may be small.

According to an embodiment, the light emitting device further comprises a barrier between neighboring light propagating units in the plurality of light propagating units, wherein the barrier extends along the waveguides of the neighboring light propagating units and is configured to prevent cross-talk between the neighboring light propagating units.

This may ensure that a beam shape output by the light emitting device is accurately controlled by the respective light propagating units.

According to a second aspect, there is provided a display comprising a light emitting device according to the first aspect.

Effects and features of the second aspect are largely analogous to those described above in connection with the first aspect. Embodiments mentioned in relation to the first aspect are largely compatible with the second aspect.

Thus, a display with high resolution may be provided, since the light emitting device facilitates using small light emitters. In addition, the display may provide a high directionality of emitted light.

According to a third aspect, there is provided an illumination unit comprising a light emitting device according to the first aspect.

Effects and features of the third aspect are largely analogous to those described above in connection with the first and second aspects. Embodiments mentioned in relation to the first and second aspects are largely compatible with the third aspect.

Thus, an illumination unit may be provided with an accurate control of output of light. As mentioned above, the direction of light from different light propagating units may differ. This may for instance be utilized for providing a focus of illumination of light.

According to a fourth aspect, there is provided a method for emitting light, said method comprising: emitting light by each light emitter of a group of light emitters, wherein different light emitters of the group are configured to emit light of different characteristics; coupling in light emitted by the group of light emitters at an in-coupling end of a waveguide, wherein the waveguide is arranged in relation to the light emitters of the group to receive light from different light emitters of the group at different locations of the in-coupling end; propagating light through the waveguide to a transmitting end of the waveguide, wherein the waveguide is a multimode waveguide configured to propagate light through the waveguide in dependence of the characteristics of the light for combining the light emitted by the group of light emitters at the transmitting end; coupling in light combined by the waveguide from the transmitting end of the waveguide to a receiving end of a funnel element, wherein a cross-section of the funnel element at the receiving end is smaller than a cross-section of the waveguide at the transmitting end, and wherein the receiving end of the funnel element is arranged in relation to a portion of the transmitting end; and propagating the light through the funnel element to an output end of the funnel element for output of emitted light from the output end, wherein the emitted light is a combination of light of the different characteristics emitted by the light emitters of the group of light emitters.

Effects and features of the fourth aspect are largely analogous to those described above in connection with the first, second, and third aspects. Embodiments mentioned in relation to the first, second and third aspect are largely compatible with the fourth aspect.

Thus, a method for emitting light is provided, wherein light may be output with a high directionality of emitted light.

### Brief description of the drawings

The above, as well as additional objects, features, and advantages of the present description, will be better understood through the following illustrative and non-limiting detailed description, with reference to the appended drawings. In the drawings like reference numerals will be used for like elements unless stated otherwise.
Fig. 1 is a schematic view of a light emitting device.
Fig. 2 is a cross-sectional view of a light emitting device.
Fig. 3 is another cross-sectional view of a light emitting device.
Fig. 4 is a schematic view of a display.
Fig. 5 is a flow chart of a method.

### Detailed description

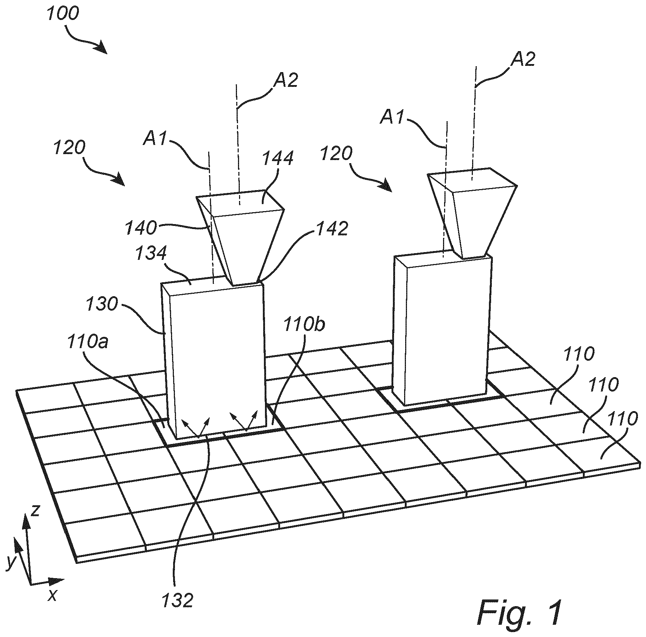

Fig. 1 schematically illustrates a light emitting device 100. The light emitting device 100 comprises a plurality of light emitters 110 for emitting light. The light emitters 110 are configured to emit light of different characteristics. Thus, the light emitters 110 may comprise a plurality of types of light emitters, wherein each type of light emitter emits light with specific characteristics.

The light emitting device 100 may thus be configured to emit light providing a combination of characteristics of light from the plurality of types of light emitters. The light emitters 110 may be referred to as belonging to sets of light emitters, wherein the light emitters belonging to a same set are configured to emit light with the same characteristics, whereas light emitters belonging to different sets are configured to emit light with different characteristics.

The light emitters 110 may be arranged in an array, as indicated in Fig. 1. The light emitters 110 may thus be regularly arranged. In addition, the light emitters of different sets may be alternatingly arranged in rows and/or columns of the array. For instance, the light emitters of different sets may be alternatingly arranged in rows of the array, whereas a same order of light emitters of different sets may be provided in each row. Thus, each column of the array may comprise light emitters belonging to one set only.

The light emitters 110 may be very small so as to provide emission of light from a small, confined area. The light emitters 110 may for instance be formed by a light emitting diode (LED) using a iii-v compound semiconductor, an organic material, a quantum dot, or a perovskite material for emitting light.

The light emitters 110 being configured to emit light from a small light emitting area may be configured to emit light in a broad range of angles. Thus, the light emitters 110 may have a large spread in a direction of light being output from the light emitters 110. The light emitting device 100 may further comprise light propagating units 120 for improving directionality of emitted light.

The light emitting device 100 comprises a plurality of light propagating units 120. The light propagating units 120 of the light emitting device 100 may all be identical. However, it is conceivable that the light propagating units 120 may be of a number of different types, as will be discussed later.

In Fig. 1, two light propagating units 120 are shown. It should be realized that light propagating units 120 may be arranged in relation to each of the light emitters 110. This is not shown in Fig. 1, in order to more clearly show the features of the light propagating units 120. For simplicity and brevity, a single light propagating unit 120 will now be discussed.

The light propagating unit 120 is associated with a group of light emitters 110a-b of the plurality of light emitters. As illustrated in Fig. 1, the light propagating unit 120 is associated with a group comprising two light emitters 110a-b. Each of the light emitters 110a-b in the group may belong to a unique set. In addition, the group of light emitters may comprise one light emitter from each set of light emitters.

The light propagating unit 120 comprises a waveguide 130. The waveguide 130 may be arranged having an in-coupling end 132 facing an emitter plane in which the plurality of light emitters 110 are arranged. The in-coupling end 132 may be parallel to the emitter plane of the light emitters 110. The light emitters 110 may be configured to emit light out of the plane. This implies that light emitted by the light emitters 110 will be incident on the in-coupling end 132 of the waveguide 130.

The waveguide 130 is arranged in relation to the light emitters 110a-b of the group to receive light from different light emitters of the group at different locations of the in-coupling end 132. However, since the light emitters 110a-b emit light with a broad range of angles, the light from neighboring light emitters may partly spatially overlap at the in-coupling end 132. The waveguide 130 is thus configured to couple in light emitted by the group of light emitters 110a-b into the waveguide 130.

The waveguide 130 may thus be configured to receive light of different characteristics at different locations of the in-coupling end 132. This further implies that light of different characteristics is spatially separated at the in-coupling end 132 of the waveguide 130.

The waveguide 130 further comprises a transmitting end 134 opposite to the in-coupling end 132. The waveguide 130 defines a central waveguide axis A1 extending from the in-coupling end 132 to the transmitting end 134.

The waveguide 130 is further configured to propagate the light from the in-coupling end 132 to the transmitting end 134. The waveguide 130 is a multimode waveguide configured to propagate the light through the waveguide 130 in dependence of the characteristics of light. By the present arrangement, the light of different characteristics being received at different spatial locations of the in-coupling end 132 may be propagated through the waveguide 130 such that the waveguide 130 combines the light emitted by the group of light emitters 110a-b at the transmitting end 134.

The waveguide 130 may be a dual mode waveguide. The dual mode waveguide may provide a beating between modes for light propagating through the waveguide. The waveguide 130 may further provide effective refractive index differences between light of different characteristics, such as light of different wavelengths. This implies that the waveguide 130 may be configured such that light being coupled into the in-coupling end 132 of the waveguide 130 at different locations of the in-coupling end 132 may be jointly coupled out of the waveguide 130 at the transmitting end 134.

The light propagating unit 120 further comprises a funnel element 140 having a receiving end 142 and an output end 144. The funnel element 140 is arranged such that the receiving end 142 is facing the transmitting end 134 of the waveguide 130. The funnel element 140 may be arranged such that the receiving end 142 is in direct contact with the transmitting end 134 of the waveguide 130. Alternatively, the funnel element 140 may be arranged such that a gap is formed between the receiving end 142 and the transmitting end 134.

The receiving end 142 of the funnel element 140 is arranged in relation to a portion of the transmitting end 134 to couple the light combined by the waveguide 130 at the transmitting end 134 into the funnel element 140. An area of the receiving end 142 of the funnel element 140 may be smaller than an area of the transmitting end 134 of the waveguide 130.

The funnel element 140 defines a central funnel axis A2 extending from the receiving end 142 to the output end 144. The central funnel axis A2 may be parallel to the central waveguide axis A1. This implies that a simple relation is provided between the funnel element 140 and the waveguide 130, facilitating manufacturing of the light emitting device 100.

Due to the waveguide 130 providing wavelength dependent effective refractive index differences between the two propagating modes, the beating of light of different characteristics differs. This implies that, light of different characteristics entering the waveguide 130 at different spatial locations, may arrive at the transmitting end 134 at a same side in relation to a symmetry axis of the waveguide 130. The receiving end 142 of the funnel element 140 may be arranged in relation to the side of the waveguide 130 at which the light arrives at the transmitting end 134. Hence, the light propagating in the waveguide 130 may be coupled entirely into the funnel element 140 combining the light emitted by the group of emitters 110a-b in the funnel element 140.

The funnel element 140 is asymmetrically arranged in relation to the waveguide 130. More specifically, the receiving end 142 is coupled to the transmitting end 132 such that the central funnel axis A2 at the receiving end 142 is displaced with respect to the central waveguide axis A1 at the transmitting end 134.

A cross-section of the funnel element 140 at the receiving end 142 is smaller than a cross-section of the waveguide 130 at the transmitting end 134. The funnel element 140 may thus be configured to receive light of a single mode and to propagate light of the single mode.

The funnel element 140 is configured to propagate the light coupled into the funnel element 140 at the receiving end 142 to the output end 144. The cross-section of the funnel element 140 at the receiving end 142 is smaller than a cross-section of the funnel element 140 at the output end 144. Thus, by light being propagated towards the wider cross-section in the funnel element 140, the mode propagating in the funnel element 140 becomes wider at the output end 144.

The funnel element 140 may be provided with an adiabatic tapering of such that an angle of a sidewall to a normal to the receiving end 142 is larger at the receiving end 142 than at the output end 144. This may be advantageous in ensuring that light coupled into the receiving end 142 is propagated within the funnel element 140 to the output end 144 and may be important if a steep tapering of the funnel element 140 is used.

However, as shown in Fig. 1, a sidewall of the funnel element 140 may extend along a straight line between the receiving end 142 and the output end 144. This implies that a shape of the funnel element is simple and may still provide a funnel element 140 that effectively propagates the light received at the receiving end 142 to the output end 144, in particular if a length (i.e., distance between the receiving end 142 and the output end 144) of the funnel element 140 is larger or much larger than a size of the wavelength of light.

The light propagating unit 120 may be configured to output emitted light through the output end 144. The emitted light is a combination of light of the different characteristics emitted by the light emitters 110a-b of the group belonging to different sets.

Conservation of etendue causes an emission cone from the output end 144 of the funnel element 140 to be narrower than a cone entering the light propagating unit 120, because the mode is wider at the output end 144. Thus, the light emitting device 100 may provide high directionality of emitted light.

The light propagating unit 120 may be configured to output emitted light in an emission cone having an angle at the apex of the emission cone smaller than 40°, such as smaller than 30°. For instance, the angle at the apex of the emission cone may be in a range of 20-30°, which may meet target requirements of augmented, mixed, or virtual reality displays.

As mentioned above, the funnel element 140 may be asymmetrically arranged in relation to the waveguide 130. Thus, a displacement may be defined between the central funnel axis A2 and the central waveguide axis A1 at the transmitting end 134. This displacement may be designed such that the light output at the output end 144 of the funnel element 140 may be directed along a central axis being parallel to the emission plane.

However, it should be realized that, if the displacement is different, light will be output along a central axis having a different direction. Thus, the light propagating unit 120 may be designed for providing output of emitted light in a desired direction in relation to the emission plane. For instance, if a displacement is decreased, an angle between the central axis of emitted light and the normal of the emission plane may be increased.

The light propagating units 120 may be formed in a layer integrated with the plurality of light emitters 110. The waveguides 130 and the funnel elements 140 may be formed by a material having a higher refractive index than a material surrounding the light propagating units 120.

The material of which the funnel element 140 and the waveguide 130 of the light propagating unit 120 is made of may depend on the wavelength range for which the light propagating unit 120 is designed. The material of which the funnel element 140 and the waveguide 130 may also be a material that is compatible with semiconductor processing. This implies that semiconductor processing facilities may be used for accurately forming the small features of the funnel element 140 and the waveguide 130.

The light propagating unit 120 may be formed by a material having a high refractive index, such as a refractive index of 1.8 or higher. By way of example, the light propagating unit 120 may be made of Silicone Nitride with a refractive index of about 2.0.

Given as non-limiting examples, if the light propagating unit 120 is designed for propagation of visible light, materials such as SiₓNₓ, TiOₓ, or NbOₓ may be used in a SiOₓ environment. Given as further non-limiting examples, if the light propagating unit 120 is designed for propagation of light in the near infrared (NIR) range, materials such as amorphous Si, or Carbon rich amorphous silicon may be used.

The light emitters 110 may be configured to emit light from a small light emitting area. The light emitting area may for instance have a square shape with a size of a side of the light emitting area being smaller than 500 nm, such as smaller than 300 nm. According to an embodiment, the light emitters 110 may be configured to emit light from a light emitting area having a size of 200 nm x 200 nm.

The light propagating unit 120 may have an in-coupling end 132 having a size corresponding to a combined size of the light emitting areas of the light emitters 110a-b in the group of light emitters. The light propagating unit 120 may be configured to receive light from light emitters 110a-b arranged along a line in the array, such as along a row or a column. Although the group of light emitters is shown in Fig. 1 to include two light emitters 110a-b, it should be realized that the group of light emitters may include further light emitters, such as three light emitters, arranged on a line in the array.

The waveguide 130 of the light propagating unit 120 may thus have a rectangular cross-section. The waveguide 130 may be slightly tapered towards the in-coupling end 132 such that a cross-section of the in-coupling end 132 is smaller than a cross-section of the transmitting end 134. Alternatively, side walls of the waveguide 130 may be parallel.

The funnel element 140 may have a cross-section having a square shape. The receiving end 142 may for instance have a square shape with a size of a side of the receiving end 142 being smaller than 300 nm, such as smaller than 200 nm. The receiving end 142 may be arranged in relation to the transmitting end 134 such that a center point at the receiving end 142 is displaced in relation to a center point at the transmitting end 134 by 100 nm in one direction and no displacement in the other, perpendicular direction.

The funnel element 140 may further be configured have a square shape at the output end 144 with a size of a side of the output end 144 being larger than 500 nm, such as larger than 1 µm. With a rectangular shape of the waveguides 130, the funnel elements 140 may be rotated in relation to the waveguides 130 such that the side of the funnel element 140 is rotated in relation to a direction along a row of light emitters 110 by an angle in a range of 20-45°, such as in a range of 40-45°. This may facilitate the funnel elements 140 having a large size at the output ends 144 with the funnel elements 140 of neighboring light propagating units 120 being arranged close to each other to fill the emission plane.

The light emitters 110 may have different characteristics in that the light emitters 110 emit light of different wavelengths. This implies that the light propagating unit 120 may be configured to combine light of different wavelengths into combined light. The combined light implies that light of different wavelengths is not output from separate pixels but is rather combined and jointly output from the light emitting device 100. This implies that the light emitting device 100 may provide color uniformity for all observation angles within the emitted cone of light.

The light propagating units 120 may be associated with two light emitters 110a-b as shown in Fig. 1. Thus, the light propagating units 120 may be associated with two light emitters 110a-b emitting light of two different wavelengths. Thus, the light emitters 110a belonging to a first set are configured to emit light of a first wavelength and the light emitters 110b belonging to a second set are configured to emit light of a second wavelength. Further, the light propagating units 120 may be associated with a group of light emitters 110a-b comprising a light emitter 110a belonging to the first set and a light emitter 110b belonging to the second set. The light propagating units 120 are thus configured to output emitted light being a combination of light of the first wavelength and light of the second wavelength.

However, it should be realized that the light propagating units 120 may be associated with groups of light emitters including a larger number of light emitters, such as at least three light emitters. The light propagating units 120 may thus be configured to combine light of a plurality of wavelengths such that the emitted light from each light propagating unit 120 is a combination of light of a plurality of wavelengths. For instance, a group of three light emitters may be configured to emit blue, green, and red light, respectively.

Further, it should be realized that the light propagating units 120 need not be associated with identical groups of light emitters. Thus, different light propagating units 120 may be associated with light emitters emitting light of different combinations of characteristics. This implies that the light propagating units 120 may have slightly different dimensions to be adapted to combining light of different characteristics.

For instance, the plurality of light emitters may further comprise a third set of light emitters and a fourth set of light emitters, wherein the light emitters belonging to the third set are configured to emit light of a third wavelength and the light emitters belonging to the fourth set are configured to emit light of a fourth wavelength. The plurality of light propagating units 120 may then comprise a first set of light propagating units and a second set of light propagating units. The light propagating units belonging to the first set are each associated with a group of light emitters comprising a light emitter belonging to the first set and a light emitter belonging to the second set and the light propagating units belonging to the first set are configured to output emitted light being a combination of light of the first wavelength and light of the second wavelength. Further, the light propagating units belonging to the second set are each associated with a group of light emitters comprising a light emitter belonging to the third set and a light emitter belonging to the fourth set and the light propagating units belonging to the second set are configured to output emitted light being a combination of light of the third wavelength and light of the fourth wavelength.

Given as an example, the light emitters of the first set may be configured to emit blue light and the light emitters of the second set may be configured to emit yellow light. Thus, the light propagating units of the first set may be configured to output emitted light being a combination of blue and yellow light. Further, the light emitters of the third set may be configured to emit cyan light and the light emitters of the fourth set may be configured to emit red light. Thus, the light propagating units of the second set may be configured to output emitted light being a combination of cyan and red light.

This may be utilized for ensuring that the light emitting device is configured to efficiently output emitted light over a broad range of wavelengths. It should further be realized that the light emitters 110 may include light emitters emitting light in a visible range as well as light emitters emitting light in an ultraviolet range and/or infrared range.

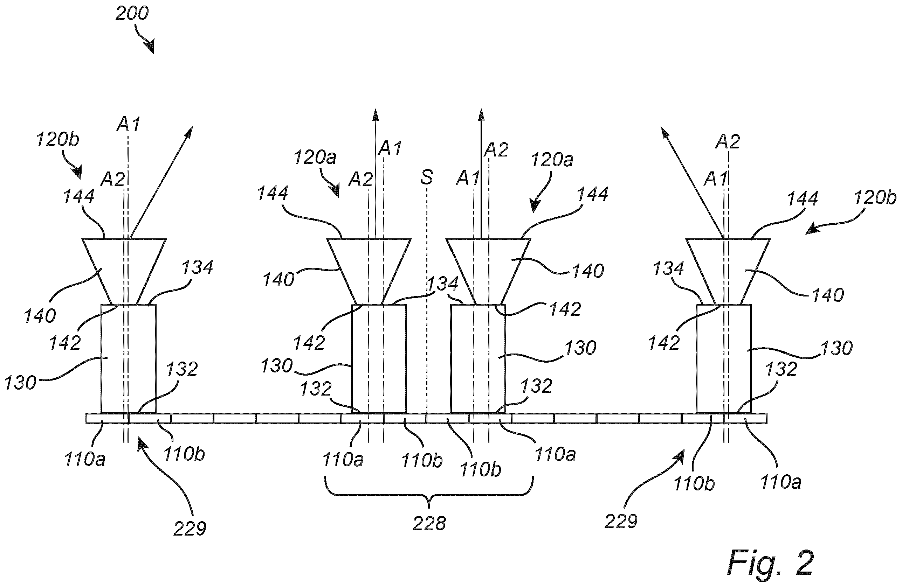

Referring now to Fig. 2, different light propagating units 120 may be provided with the funnel element 140 being differently asymmetrically arranged in relation to the waveguide 130. Thus, the displacement between the central funnel axis A2 and the central waveguide axis A1 at the transmitting end 134 may differ for different light propagating units 120. The displacement may be configured to control a direction of the light output at the output end 144 of the funnel element 140.

Fig. 2 illustrates a light emitting device 200. The light emitting device 200 comprises a plurality of light propagating units 120a, 120b arranged across an array comprising a plurality of light emitters 110. The light propagating units 120a, 120b are of at least two different types, i.e., a first type and a second type, such that the plurality of light propagating units comprises at least a first light propagating unit 120a and a second light propagating unit 120b. The light emitting device 200 shares some of the features with the light emitting device 100 described in relation to Fig. 1, the details of which are not repeated here.

In the present arrangement, light output from a central portion of the array of light propagating units may be output in a direction along a normal or close to a normal of the emission plane. By way of example, light output from a central portion of the array of light propagating units may be output into an emission cone defined by angles of the emitted light in relation to the normal of the emission plane being in the interval of θ = ±10°. Further, light output from a peripheral portion of the array of light propagating units may be output into an oblique angle. By way of example, the angles of emitted light from the light propagating units at a peripheral portion of the array in relation to the normal of the emission plane may be larger than ±10°.

The plurality of light propagating units 120a, 120b is arranged in a central zone 228 arranged at a central portion of the array, and a peripheral zone 229 arranged at a peripheral portion of the array.

For light propagating units 120a arranged in the central zone 228, the funnel element 140 and the waveguide 130 have a first asymmetric coupling with a first displacement of the central funnel axis A2 and the central waveguide axis A1 at the transmitting end 134. For light propagating units 120b arranged in the peripheral zone 229, the funnel element 140 and the waveguide 130 have a second asymmetric coupling with a second displacement of the central funnel axis A2 and the central waveguide axis A1 at the transmitting end 134. In the present arrangement, the first displacement is larger than the second displacement. The light propagating units 120a having the first asymmetric coupling are configured for efficient propagation and output of light along a central axis being parallel to the normal of the emission plane (and a normal to the output end 144). The light propagating units 120b having the second asymmetric coupling with the second displacement, smaller than the first displacement, between the funnel element 140 and the waveguide 130, are configured for efficient propagation and output of light along a central axis forming an oblique angle to the normal of the emission plane (and a normal to the output end 144).

By the present arrangement, the light emitting device 200 may be configured to output light at different angles from different light propagating units 120a, 120b of the plurality of light propagating units 120a, 120b, depending on their location in the array. Since the different light propagating units 120a, 120b are arranged with different asymmetric coupling of the funnel element 140 to the waveguide 130 depending on their location in the array, the light emitting device 200 may be configured to form a focus of the emitted light from the plurality of light propagating units 120a, 120b.

In Fig. 2, a gap is illustrated between the central zone 228 and the peripheral zone 229. However, it should be understood that in the light emitting device 200 also this region is provided with light propagating units. It is conceivable that the central zone 228 and or the peripheral zone are expanded such that the gap is eliminated. By way of example, the gap may comprise light propagating units 120a having the first asymmetric coupling, or the gap may comprise light propagating units 120b having the second asymmetric coupling, or the gap may comprise a combination thereof. As yet another alternative, the gap may represent an intermediate zone comprising light propagating units having an asymmetric coupling different from the first and second asymmetric couplings.

It should also be realized that the plurality of light propagating units 120a, 120b is arranged to present a symmetry axis S. The asymmetric coupling of the light propagating units 120a, 120b on a first side of the symmetry axis S, is mirrored with respect to the asymmetric coupling of the light propagating units 120a, 120b on an opposite second side of the symmetry axis S. In the present example, light is output along a normal of the emission plane at the central zone 228 of the array, and to be output at an increasingly oblique angle with increasing distance from the central zone 228 of the array. However, the angle at which the light is output may have opposite direction at the first and second sides of the symmetry axis S. In other words, the angle may be mirrored with respect to the symmetry axis S. Thus, in order to provide a focusing of light output from the light emitting device 200, the light propagating units 120a, 120b may also be mirrored.

By the term "mirrored" is here meant that, at a given distance from the symmetry axis, the displacement of the central funnel axis A2 at the receiving end 142 with respect to the central waveguide axis A1 at the transmitting end 134 for a light propagating unit on the second side of the symmetry axis is equally large as for a corresponding light propagating unit on the first side of the symmetry axis, however displaced in an opposite direction in the plane of the transmitting end 134. Put differently, the asymmetric coupling of a light propagating unit on the second side of the symmetry axis is the same as for a light propagating unit on the first side, but displaced in the opposite direction.

It should be understood that, mirroring the light propagating units 120a, 120b with respect to the symmetry axis S may also mirror the order at which wavelength bands should be in-coupled at the in-coupling end 132 of the waveguide 130. Thus, it is conceivable that if the light propagating units 120a, 120b on the first side of the symmetry axis S receive wavelength bands in a descending order in a given direction, then the light propagating units 120a, 120b on the second side of the symmetry axis S may receive the wavelength bands in ascending order in the same direction.

The light emitting device 200 may for instance be used as an illumination unit providing output of light with color uniformity.

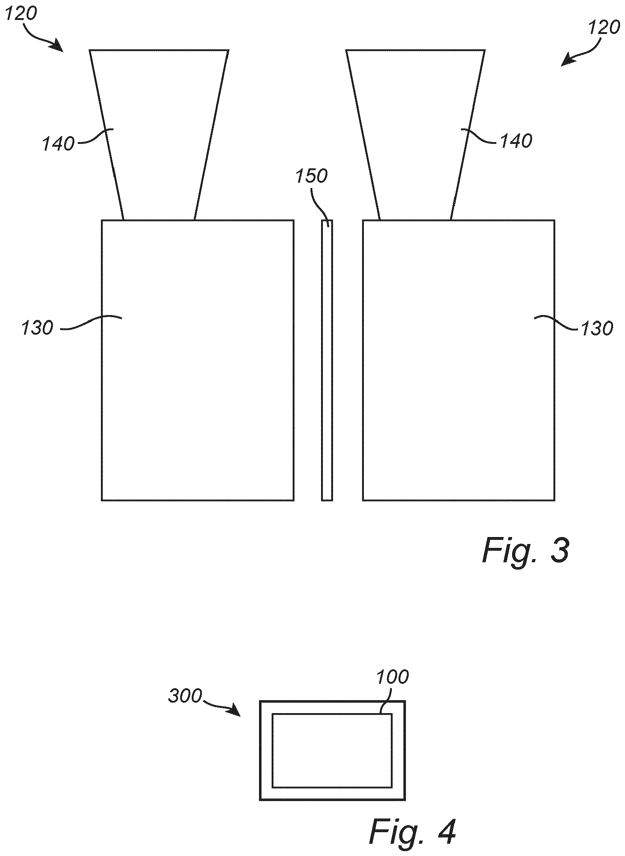

Referring now to Fig. 3, a cross-section of the light emitting device 100 according to one embodiment is shown. As shown in Fig. 3, the light emitting device 100 may comprise a barrier 150 between neighboring light propagating units 120.

The barrier 150 may extend along the waveguides 130 of the neighboring light propagating units 120. The barrier 150 may be configured to absorb light. For instance, the barrier 150 may be formed by a metal.

The barrier 150 may be configured to absorb light escaping through a side wall of a light propagating unit 120. The barrier 150 may thus be configured to prevent or reduce cross-talk between the neighboring light propagating units 120.

It should be realized that the barrier 150 may not be necessary, as there may be a very small amount of light escaping through side walls of the light propagating units 120. Thus, in other embodiments, no barrier is present between the light propagating units 120.

Referring now to Fig. 4, the light emitting device 100 may form part of a display 300.

The light emitting device 100 may thus be configured to present an image of the display 300 by emitting light from the plurality of light emitters 110. The plurality of light emitters 110 may be controlled for controlling output of emitted light so as to form a desired image.

Thanks to small-size of the light emitters 110, the display 300 may provide a high resolution image. The light emitters 110 may have a short response time allowing for a high frame rate of images. For these reasons, the display 300 may be advantageously used in augmented, mixed, and virtual reality displays. However, it should be realized that the display 300 may alternatively be used in other applications.

The light propagating units 120 may be configured to output emitted light in a narrow emission cone with emitted light being output along a central axis of the emission cone being parallel with the normal to the emission plane. Thus, a high directionality of emitted light is provided, which may be particularly useful if the display is to be viewed from a close distance.

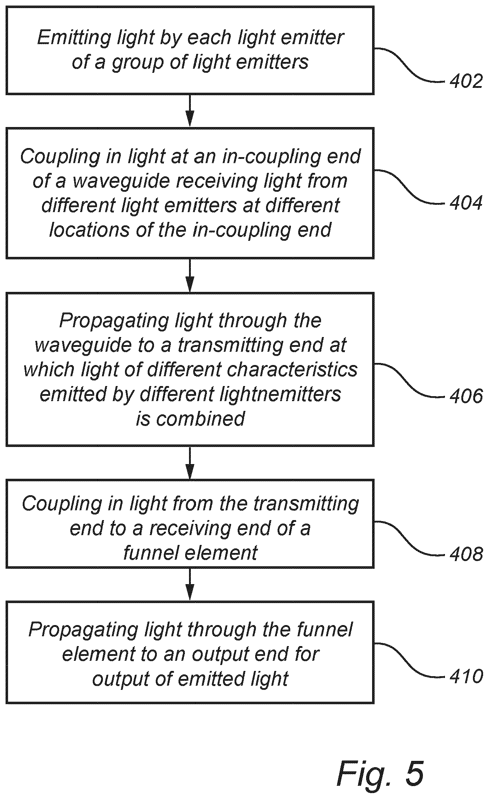

Referring now to Fig. 5, a method for emitting light will be described.

The method comprises emitting 402 light by each light emitter of a group of light emitters. Different light emitters of the group are configured to emit light of different characteristics, such as different wavelengths. For instance, the light emitters in the group may emit light of mutually unique characteristics.

Light may be emitted by a plurality of groups of light emitters arranged in a common emitter plane. The groups of light emitters may have a common composition, such that each group of light emitters emit light of a common combination of characteristics, such as a common combination of wavelengths. However, according to an embodiment, different groups of light emitters may be defined. For instance, a first group of light emitters may emit light of a first wavelength and a second wavelength, whereas a second group of light emitters may emit light of a third wavelength and a fourth wavelength.

The method further comprises coupling 404 in light emitted by the group of light emitters at an in-coupling end of a waveguide. The waveguide is arranged in relation to the light emitters of the group to receive light from different light emitters of the group at different locations of the in-coupling end. The waveguide is associated with the group of light emitters such that light emitted from the light emitters of the group is coupled into the waveguide, whereas light emitted from other light emitters is not coupled into the waveguide (but instead coupled into other waveguides associated with the other light emitters).

The method further comprises propagating 406 light through the waveguide to a transmitting end of the waveguide. The waveguide is a multimode waveguide configured to propagate light through the waveguide in dependence of the characteristics of the light for combining the light emitted by the group of light emitters at the transmitting end. Thus, the light of different characteristics being coupled into the waveguide at separate spatial locations of the in-coupling end is combined at the transmitting end of the waveguide.

The method further comprises coupling 408 in light combined by the waveguide from the transmitting end of the waveguide to a receiving end of a funnel element. A cross-section of the funnel element at the receiving end is smaller than a cross-section of the waveguide at the transmitting end, and the receiving end of the funnel element is arranged in relation to a portion of the transmitting end. The light may be coupled into the funnel element for propagating light of a single mode in the funnel element.

The funnel element may be asymmetrically arranged in relation to the waveguide. The asymmetrical arrangement of the funnel element in relation to the waveguide may control a direction of light being output by the funnel element.

The method further comprises propagating 410 the light through the funnel element to an output end of the funnel element for output of emitted light from the output end. The emitted light that is output by the funnel element is a combination of light of the different characteristics emitted by the light emitters of the group of light emitters.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A light emitting device (100; 200) comprising:
a plurality of light emitters (110) comprising at least a first set of light emitters and a second set of light emitters, wherein light emitters belonging to different sets are configured to emit light of different characteristics;
a plurality of light propagating units (120), wherein each light propagating unit (120) is associated with a group of light emitters (110a-b) of the plurality of light emitters, wherein the group of light emitters (110a-b) comprises light emitters belonging to different sets, wherein each light propagating unit (120) comprises:
a waveguide (130) having an in-coupling end (132) and a transmitting end (134), wherein the waveguide (130) is configured to couple in light emitted by the group of light emitters (110a-b) at the in-coupling end (132), wherein the waveguide (130) is arranged in relation to the light emitters (110a-b) of the group to receive light from different light emitters of the group at different locations of the in-coupling end (132), wherein the waveguide (130) is a multimode waveguide configured to propagate light through the waveguide (130) in dependence of the characteristics of the light for combining the light emitted by the group of light emitters (110a-b) at the transmitting end (134);
a funnel element (140) having a receiving end (142) and an output end (144), wherein a cross-section of the funnel element (140) at the receiving end (142) is smaller than a cross-section of the funnel element (140) at the output end (144) and wherein a cross-section of the funnel element (140) at the receiving end (142) is smaller than a cross-section of the waveguide (130) at the transmitting end (134), wherein the receiving end (142) of the funnel element (140) is arranged in relation to a portion of the transmitting end (134) to couple the light combined by the waveguide (130) at the transmitting end (134) into the funnel element (140), and to propagate the light to the output end (144) for output of emitted light by the light propagation unit (120), wherein the emitted light is a combination of light of the different characteristics emitted by the light emitters belonging to the different sets.

2. The light emitting device according to claim 1, wherein the plurality of light emitters (110) is arranged in an emitter plane, wherein the plurality of light propagating units (120) is arranged with surfaces of the in-coupling ends (132) of the waveguides (130) of the light propagating units (120) being parallel with the emitter plane.

3. The light emitting device according to claim 1 or 2, wherein the plurality of light propagating units (120) is formed in a layer integrated with the plurality of light emitters (110), wherein the waveguides (130) and funnel elements (140) of the light propagating units (120) are formed by a material having a high refractive index surrounded by a material having a low refractive index.

4. The light emitting device according to any one of the preceding claims, wherein the funnel element (140) is asymmetrically arranged in relation to the waveguide (130) such that a central funnel axis (A2) at the receiving end (142) is displaced from a central waveguide axis (A1) at the transmitting end (134).

5. The light emitting device according to claim 4, wherein the central funnel axis (A2) is parallel to the central waveguide axis (A1).

6. The light emitting device according to any one of the preceding claims, wherein the light emitters (110a) belonging to the first set are configured to emit light of a first wavelength and the light emitters (110b) belonging to the second set are configured to emit light of a second wavelength, wherein the light propagating units (120) being associated with a group of light emitters (110a-c) comprising a light emitter (110a) belonging to the first set and a light emitter (110b) belonging to the second set are configured to output emitted light being a combination of light of the first wavelength and light of the second wavelength.

7. The light emitting device according to claim 6, wherein the plurality of light emitters further comprises a third set of light emitters and a fourth set of light emitters, wherein the light emitters belonging to the third set are configured to emit light of a third wavelength and the light emitters belonging to the fourth set are configured to emit light of a fourth wavelength, wherein the plurality of light propagating units comprises a first set of light propagating units and a second set of light propagating units, wherein the light propagating units belonging to the first set are each associated with a group of light emitters comprising a light emitter belonging to the first set and a light emitter belonging to the second set and the light propagating units belonging to the first set are configured to output emitted light being a combination of light of the first wavelength and light of the second wavelength, and the light propagating units belonging to the second set are each associated with a group of light emitters comprising a light emitter belonging to the third set and a light emitter belonging to the fourth set and the light propagating units belonging to the second set are configured to output emitted light being a combination of light of the third wavelength and light of the fourth wavelength.

8. The light emitting device according to any one of the preceding claims, wherein each light propagating unit (120) is configured to output emitted light in an emission cone smaller than 40°, such as smaller than 30°.

9. The light emitting device according to any one of the preceding claims, wherein each of the light emitters (110a-b) has a light emitting area with a size across the light emitting area smaller than 500 nm, such as smaller than 300 nm, and wherein the output end (144) of the funnel element (140) of each of the light propagating units (120) has a size across the output end (144) larger than 500 nm, such as larger than 1 µm.

10. The light emitting device according to any one of the preceding claims, wherein each of the light emitters (110a-b) comprises a light emitting diode comprising a iii-v compound semiconductor, an organic material, a quantum dot, or a perovskite material for emitting light.

11. The light emitting device according to any one of the preceding claims, wherein the waveguide (130) is a dual mode waveguide and the funnel element (140) is configured to propagate light of a single mode.

12. The light emitting device according to any one of the preceding claims, further comprising a barrier (150) between neighboring light propagating units (120) in the plurality of light propagating units, wherein the barrier (150) extends along the waveguides (130) of the neighboring light propagating units (120) and is configured to prevent cross-talk between the neighboring light propagating units (120).

13. A display (300) comprising a light emitting device (100) according to any one of the preceding claims.

14. A method for emitting light, said method comprising:
emitting (402) light by each light emitter of a group of light emitters, wherein different light emitters of the group are configured to emit light of different characteristics;
coupling (404) in light emitted by the group of light emitters at an in-coupling end of a waveguide, wherein the waveguide is arranged in relation to the light emitters of the group to receive light from different light emitters of the group at different locations of the in-coupling end;
propagating (406) light through the waveguide to a transmitting end of the waveguide, wherein the waveguide is a multimode waveguide configured to propagate light through the waveguide in dependence of the characteristics of the light for combining the light emitted by the group of light emitters at the transmitting end;
coupling (408) in light combined by the waveguide from the transmitting end of the waveguide to a receiving end of a funnel element, wherein a cross-section of the funnel element at the receiving end is smaller than a cross-section of the waveguide at the transmitting end, and wherein the receiving end of the funnel element is arranged in relation to a portion of the transmitting end; and
propagating (410) the light through the funnel element to an output end of the funnel element for output of emitted light from the output end, wherein the emitted light is a combination of light of the different characteristics emitted by the light emitters of the group of light emitters.
